# EUROPÄISCHE PATENTSCHRIFT

(11) **EP 2 327 104 B1**
(45) Veröffentlichungstag und Bekanntmachung des Hinweises auf die Patenterteilung: **25.02.2015**
(21) Anmeldenummer: 09780809.1
(22) Anmeldetag: 20.07.2009
(51) Int. Cl.: H01L 31/02, G05F 1/67

(54) **PHOTOVOLTAIK-VORRICHTUNG**
PHOTOVOLTAIC DEVICE
DISPOSITIF PHOTOVOLTAÏQUE

(30) Priorität: 18.09.2008 DE 102008042199
(43) Veröffentlichungstag der Anmeldung: 01.06.2011
(73) Patentinhaber: Robert Bosch GmbH, 70442 Stuttgart (DE)
(72) Erfinder: VOLZ, Wolfgang, 73760 Ostfildern (DE); KRON, Gregor, 70569 Stuttgart (DE); MILDENSTEIN, Tobias, 71642 Ludwigsburg-Poppenweiler (DE); MIELCAREK, Paul, 72622 Nuertingen (DE)
(86) Internationale Anmeldenummer: PCT/EP2009/059275
(87) Internationale Veröffentlichungsnummer: WO 2010/031614

(56) Entgegenhaltungen:
- EP-A2- 1 635 438
- WO-A2-2007/124059

## Beschreibung

Die vorliegende Erfindung betrifft eine Photovoltaik-Vorrichtung nach dem Oberbegriff des Hauptanspruchs.

### Stand der Technik

Derartige Vorrichtungen sind aus dem Stand der Technik allgemein bekannt. So ist beispielsweise aus WO 2007/124059 A2 eine Photovoltaik-Vorrichtung offenbart, die alle Merkmale des Oberbegriffs des Hauptanspruchs aufweist. Da sich im normalen Betrieb einer Photovoltaik-Anlage (Solarstromanlage) durch Umgebungseinflüsse die Sonneneinstrahlung sowie die Modultemperatur des Photovoltaik-Moduls ändert, ist es Aufgabe einer nachgeschalteten Leistungselektronik, die elektrische Spannung am Photovoltaik-Modul stets auf den optimalen Punkt in der Strom-Spannungs-Kennlinie zu regeln, bei welchem die maximale elektrische Leistung erzeugt wird. Die -- ansonsten bekannte -- Baugruppe zum Durchführen dieser optimalen Strom-Spannungs-Arbeitspunkteinstellung wird als "Maximum Power Point Tracker"(MPPT oder MPP-Tracker) bezeichnet und übernimmt eine Schlüsselfunktion für einen Solarwechselrichter, welcher dann die Anbindung der Photovoltaik-Vorrichtung an das Stromnetz ermöglicht.

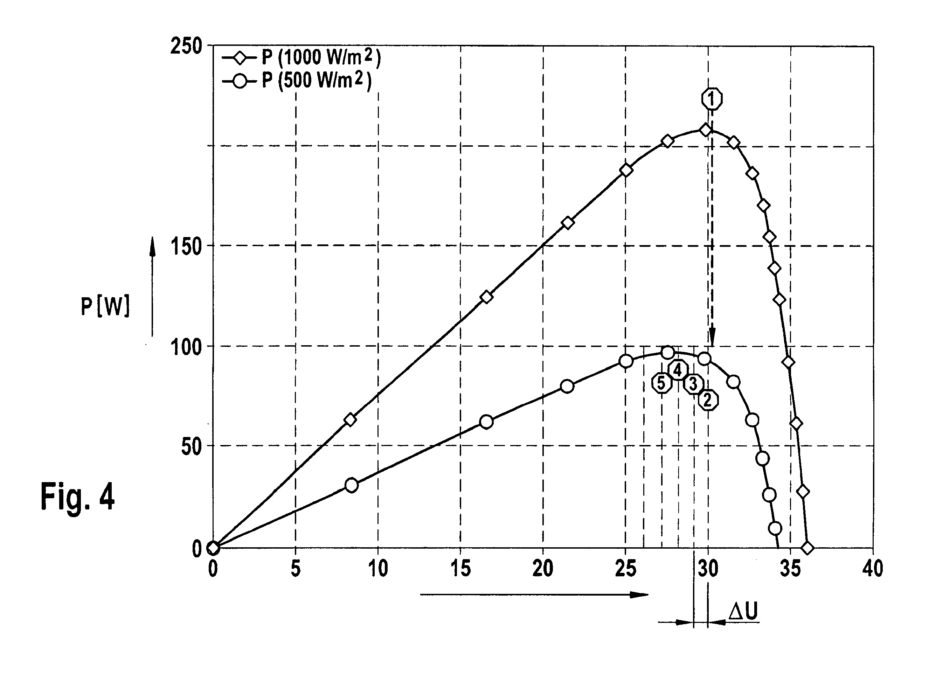

Die Fig. 4 zeigt die Wirkungsweise eines solchen bekannten MPP-Trackers im Leistungs-/Spannungsdiagramm. Die obere Kurve, entsprechend einer starken Lichteinstrahlung auf das zugehörige Photovoltaik-Modul, zeigt einen Punkt des Leistungsmaximums (1), welcher von einer beschriebenen MPP-Tracker-Einheit für den nachgeschalteten Wechselrichter eingestellt wird. Eine Verringerung der Lichteinstrahlung, wie in der unteren Diagrammkurve verdeutlicht, führt zu einer Verschiebung des Leistungsmaximums auf dieser Kurve (im Diagramm nach links), wobei der MPP-Tracker dies durch aufeinanderfolgendes Verringern des Spannungs-Arbeitspunkts um eine vorbestimmte Spannungsdifferenz ΔU entlang der Punkte (2) bis (5) zum Einstellen des Leistungsmaximums auf dieser Kurve erreicht.

Allerdings richtet sich die Wirkungsweise bekannter MPP-Vorrichtungen nach einer maximalen Leistung (bzw. maximal entnehmbaren Leistung) eines Photovoltaik-Moduls, wobei insbesondere Abschattungen von Solarzellen oder dergleichen leistungsbeeinflussende Faktoren, wie sie im täglichen Betrieb auftreten können, nur durch den Tracker berücksichtigt werden. Gerade verschattete Zellen innerhalb eines Photovoltaik-Moduls können jedoch durch eine Abschattung stark belastet und damit beansprucht werden, was nicht nur eine (nachteilige) Degradation dieser Zellen bewirken kann, sondern das gesamte Leistungsbild des Moduls nachteilig beeinflusst: Da nämlich eine (relativ zu benachbarten Zellen) abgeschattete Zelle elektrisch als Verbraucher wirken kann, erzeugt dies beträchtliche Asymmetrie und einen Leistungsverlust des Photovoltaik-Moduls, verbunden mit der bereits erwähnten Degradations- und Zerstörungsgefahr (etwa aufgrund wärmeempfindlicher Strukturen).

Aus dem Stand der Technik ist es daher bekannt, derartigen nachteiligen Wirkungen zu begegnen durch sogenannte Bypassdioden, nämlich direkt in ein Photovoltaik-Modul integrierte und jeweilige Solarzellen überbrückende Dioden, welche so geschaltet sind, dass sie im durch eine Verschattung bewirkten elektrischen Zustand der Zelle einen Sperrbetrieb der Zelle(n) überbrücken.

Auch diese bekannte und allgemein übliche Maßnahme des Einsatzes von Bypassdioden ist jedoch in vielen Anwendungsfällen nicht optimal, denn nicht nur erhöhen modulintegrierte Bypassdioden die Produktionskosten, auch wird etwa durch eine defekte Bypassdiode die Ausfallwahrscheinlichkeit eines Photovoltaik-Moduls erhöht, ebenso wie Bypassdioden selbst -- im überbrückten Sperrbetrieb eine oder mehrere Zellen -- leistungsmindernd als Verbraucher wirken können. Oft überbrücken Bypassdioden zudem mehrere Zellen, sodass dann auch unverschattete Zellen nicht mehr zum Leistungsertrag beitragen können.

Zudem ist bei sogenannten organischen Photovoltaik-Zellen bzw. mit anorganischer Dünnschichttechnik realisierten Photovoltaik-Zellen eine Integration von Bypassdioden -- verfahrensbedingt -- unmöglich oder erfordert beträchtlichen Aufwand.

### Offenbarung der Erfindung

### Technische Aufgabe

Der vorliegenden Erfindung liegt daher die Aufgabe zugrunde, eine Photovoltaik-Vorrichtung der gattungsgemäßen Art im Hinblick auf ihre elektrischen Leistungs- und Betriebseigenschaften bei verschatteten bzw. teilverschatteten Betriebszuständen des Photovoltaik-Moduls zu optimieren, insbesondere die Notwendigkeit zusätzlicher aufwändiger Bypassdioden zu reduzieren oder ganz zu überwinden und die bekannte Vorrichtung im Hinblick auf ihre Widerstandsfähigkeit gegen abschattungsbedingte Degradation bzw. Zerstörung zu verbessern und den Energieertrag im Abschattungsfall zu erhöhen sowie den Gesamtertrag über die Lebensdauer des Moduls zu erhöhen.

### Technische Lösung

Die Aufgabe wird durch die Photovoltaik-Vorrichtung mit den Merkmalen des Hauptanspruchs gelöst; vorteilhafte Weiterbildungen der Erfindung sind in den Unteransprüchen beschrieben. In den Rahmen der Erfindung fallen zudem sämtliche Kombinationen aus zumindest zwei von in der Beschreibung, den Ansprüchen und/oder den Figuren offenbarten Merkmalen.

In erfindungsgemäß vorteilhafter Weise wird eine (Teil-)Verschattung des Photovoltaik-Moduls durch die Erfassungseinheit erfasst, und es erfolgt als Reaktion auf die Erfassung eine Verschiebung des Strom-Spannungs-Arbeitspunkts durch den MPP-Tracker(-Mittel), sodass mit der dadurch bewirkten Auslenkung aus dem optimalen Leistungspunkt ein Betrieb des Photovoltaik-Moduls erreicht wird, welcher mögliche Schädigungen einzelner (verschatteter) Zellen ausschließt; insbesondere erfolgt die erfindungsgemäße, verschattungsabhängige Arbeitspunktverschiebung so, dass bevorzugt keine der Solarzellen (und damit auch nicht eine abgeschattete Solarzelle) einen negativen elektrischen Leistungsdurchsatz im abgeschatteten Betrieb besitzt, oder eine (zellenspezifische) Toleranzgrenze überschreitet, oberhalb welcher die Zelle geschädigt werden können, wobei damit insbesondere auch wirksam (ansonsten übliche) Bypassdioden überflüssig gemacht werden und ein höherer Energieertrag über die Zellen-Gesamtlebensdauer ermöglicht werden kann.

In soweit ist eine "vorbestimmte Spannungsänderung" im Sinne der Erfindung insbesondere auch eine Spannungsänderung zu verstehen, wie sie dieser Toleranzschwelle der betreffenden Solarzelle im Hinblick auf die Degradationsgefahr entspricht; Mit anderen Worten, gemäß der Erfindung erfolgt das Erfassen der vorbestimmten Spannungsänderung so, dass die Spannungsänderung von zellenspezifischen Eigenschaften abhängig ist, sodass insbesondere auch nicht der Fall ausgeschlossen wird, dass eine Zellenspannung auch negativ sein kann, sofern nicht eine Zellenbeschädigung oder dergleichen lebensdauerbeeinträchtigende Wirkung vorliegt. Im Rahmen der vorliegenden Erfindung ist dabei zudem eine Erfassung der "Zellenspannung" einer entsprechenden Zellenstromerfassung äquivalent anzusehen, sodass insbesondere auch von der vorliegenden Erfindung jegliche Ausführungsformen umfasst sind, welche zur Realisierung der beschriebenen Prinzipien keine vorbestimmte Spannungsänderung, sondern eine vorbestimmte, dem Abschattungszustand entsprechende Stromänderung detektieren.

Zum einen liegt der vorliegenden Erfindung der Gedanke zugrunde, die Erfassungseinheit so auszubilden, dass diese anhand einer jeweiligen detektierten Zellenspannung (bzw. Zellenstrom, s.o.) der Solarzellen einen (Teil-)Abschattungszustand erkennt; erfindungsgemäß vorteilhaft und weiterbildungsgemäß wird dies bewirkt durch eine jeder Solarzelle zugeordnete Leitung zur Spannungserfassung, wobei die erfindungsgemäße Erfassungseinheit geeignet relative Spannungsabweichungen (bzw. Stromabweichungen, s.o.) einer (abgeschatteten) Solarzelle relativ zu benachbarten Solarzellen feststellt, ein entsprechendes Erfassungssignal generiert und dieses dann die erfindungsgemäße Arbeitspunktverschiebung zur Leistungsabsenkung auslöst.

Die vorliegenden Betrachtungen im Rahmen der Erfindung gelten analog auch für Solarzellenmodule bzw. auf Modulebene, sodass es insbesondere von der Erfindung umfasst ist, die detektierte vorbestimmte Spannungsänderung nicht auf eine einzelne Stellenspannung, sondern auf eine Gruppe (etwa Modul) vorbestimmter Zellen anzuwenden.

Ein alternativer Gedanke im Rahmen der vorliegenden Erfindung zum Erfassen eines (Teil-)Abschattungszustands von Solarzellen besteht darin, unmittelbar die abschattungsrelevanten Parameter zu erfassen, nämlich insbesondere einen Grad einer Licht-(Sonnen-)Einstrahlung auf das Photovoltaik-Modul und/oder einen Temperaturzustand des Moduls (bzw. der einzelnen Zellen). Eine im Rahmen der Erfindung vorgesehene, der Parameter-Erfassungseinheit nachgeschaltete Vergleichseinheit stellt dann im Vergleich mit vorbestimmten bzw. voreingestellten Normwerten fest, ob ein aktueller erfasster Parameterzustand (d.h. Lichteinstrahlung, Temperatur od. dgl.) einem unverschatteten oder aber einem verschatteten Zustand entspricht und löst entsprechend und analog zur vorbeschriebenen Vorgehensweise eine leistungsabsenkende Verschiebung des Arbeitspunkts aus, sodass wiederum ein Betrieb des Photovoltaik-Moduls sichergestellt werden kann, welcher jegliche nachteilige Degradationsgefahr vermeidet.

Während die vorliegende Erfindung sich insbesondere eignet, im Zusammenhang mit organischen Solarzellen und/oder anorganischen Dünnschicht-Solarzellen verwendet zu werden, ist der Einsatzbereich der vorliegenden Erfindung keinesfalls hierauf beschränkt, vielmehr wird durch die vorliegende Erfindung vorteilhaft der Weg beschritten, kostengünstige Herstellbarkeit, insbesondere durch Vermeidung ansonsten notwendiger Bypassdioden, mit hoher Betriebssicherheit, langen, degradationsfreien Standzeiten und optimiertem Ertragsbetrieb zu kombinieren.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: ein schematisches Blockschaltbild der Photovoltaik-Vorrichtung gemäß einer ersten, bevorzugten Ausführungsform der vorliegenden Erfindung;
- Fig. 2: ein schematisches Prinzipschaltbild von Funktionskomponenten zur Realisierung der Erfindung gemäß einer vorteilhaften Variante;
- Fig. 3: ein schematisches Blockschaltbild zur Realisierung der Erfindung gemäß Fig. 1 und
- Fig. 4: ein Leistungs-Spannungsdiagramm zum Verdeutlichen einer MPP-Tracker-Funktion zum Einstellen (Verfolgen) eines Leistungsmaximums auf einer jeweiligen Leistungskurve.

### Ausführungsformen der Erfindung

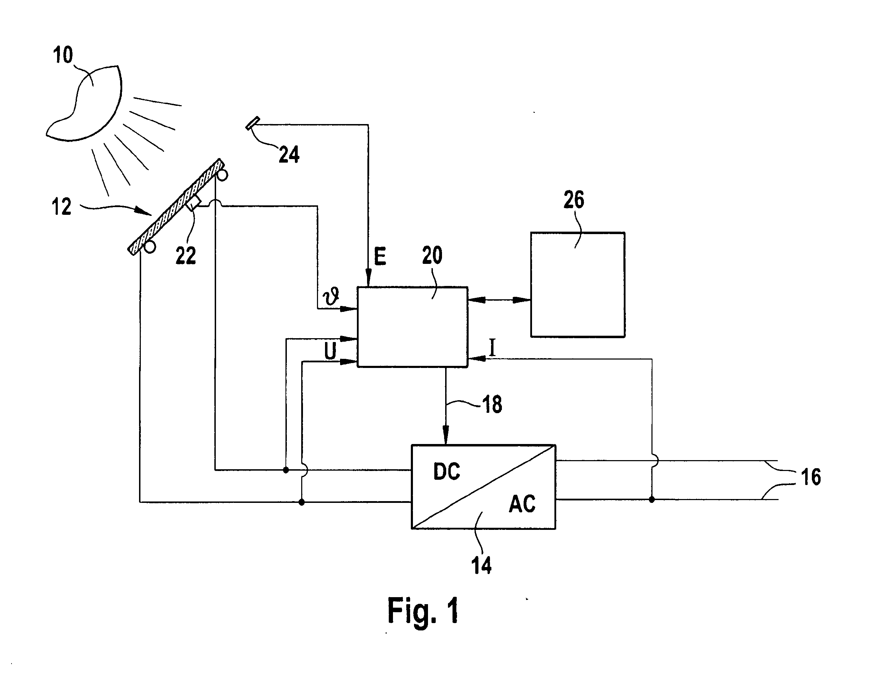

Das Prinzipschaltbild der Fig. 1 verdeutlicht anhand von Funktionsblöcken den Aufbau und die Wirkungsweise einer ersten Ausführungsform der vorliegenden Erfindung.

So bezeichnet das Bezugszeichen 10 symbolisch eine Strahlungsquelle, welche im Betriebszustand ein Photovoltaik-Modul 12 beleuchtet; im Betriebszustand kann dabei das Photovoltaik-Modul 12 vollflächigen oder partiellen (d.h. lediglich einzelne Solarzellen des Photovoltaik-Moduls betreffenden) Abschattungen ausgesetzt sein.

In ansonsten bekannter Weise wirkt das Photovoltaik-Modul 12 zusammen mit einem nachgeschalteten Wechselrichter 14, welcher das Gleichspannungssignal des Moduls 12 umsetzt in ein zur Einspeisung in ein Stromversorgungsnetz am Netzausgang 16 geeignetes Wechselspannungssignal. In diesem Zusammenhang ist insbesondere auch die Eignung der vorliegenden Erfindung für mobile Kleingeräte festzustellen, wobei insbesondere Vorrichtungen der erfindungsgemäß beanspruchten Art zum Laden von Akkus oder zum unmittelbaren Betreiben mobiler Kleingeräte geeignet sind.

Im Rahmen des beschriebenen Ausführungsbeispiels der Erfindung empfängt der Wechselrichter 14 ein Arbeitspunkt-Steuersignal über eine Steuersignalleitung 18 von einer Steuereinheit 20, welche wiederum Parameterdaten des Photovoltaik-Moduls 12 in Form eines von einem Temperatursensor 22 unmittelbar am Photovoltaik-Modul 12 gemessenen Temperatursignals sowie ferner ein Strahlungssignal von einem benachbart angeordneten Einstrahlungssensor 24 empfängt.

Neben dem Einstrahlungssignal E und dem Temperatursignal ϑ empfängt die Steuereinheit 20 zusätzlich die aktuelle vom Photovoltaik-Modul 12 generierte Gleichspannung U.

Die Wirkungsweise der Steuereinheit 20 besteht nunmehr darin, durch Vergleich dieser Parameterwerte mit in einer zugeordneten Permanentspeichereinheit 26 abgelegten Vorgabe- bzw. Normdaten (entsprechend etwa tabellarisch abgelegten Kennlinienwerten) festzustellen, ob, etwa durch einen abweichenden Wert der Einstrahlung E, ein (Teil-)Abschattungszustand vorliegt, woraufhin dann die Steuereinheit 20 über die Steuersignalleitung 18 eine Arbeitspunktverschiebung des Wechselrichters 14 vornimmt, hin zu einem Betriebs-Arbeitspunkt, bei welchem im beschriebenen Ausführungsbeispiel jede Solarzelle des Photovoltaik-Moduls 12 oberhalb einer spezifischen, zellabhängigen Toleranzgrenze (im Sinne einer Degradationsschwelle) arbeitet und entsprechend eine Degradation bzw. andere leistungsmindernde Verschlechterung verhindert wird. Soweit durch die Arbeitspunktverschiebung eine aktuelle Leistungsreduktion auftritt, wird diese jedoch durch den lebensdauerabhängigen Gesamt-Leistungsertrag einer Zelle bzw. des Gesamtsystems mehr als aufgewogen, sodass über die gesamte Lebensdauer ein deutlicher Ertragsvorteil realisiert wird.

Auf diese Weise kann - durch entsprechend leistungsmindernde Einstellung des Wechselrichter-Arbeitspunktes - verhindert werden, dass die betreffenden abgeschalteten Solarzellen degradieren bzw. beschädigt werden, was sich wiederum vorteilhaft auf die Gesamtlebensdauer und Betriebssicherheit des Photovoltaik-Moduls 12 auswirkt. Vorteilhaft ist zudem, dass durch die beschriebene erfindungsgemäße Vorgehensweise das Vorsehen von eingangs zum Stand der Technik beschriebenen Bypassdioden überflüssig wird, da durch die erfindungsgemäße Arbeitspunktverstellung die durch Bypassdioden erreichte Sperrwirkung, bezogen auf eine jeweilige einzelne Solarzelle, unnötig wird.

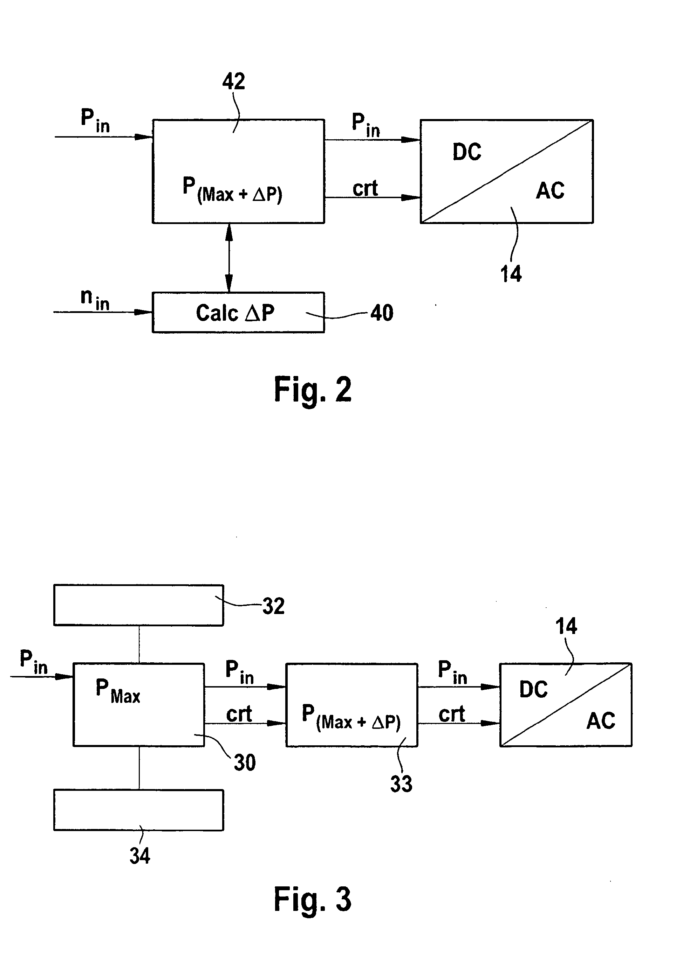

Das Prinzipschaltbild der Fig. 3 verdeutlicht auf abstrakterer Ebene dieses Prinzip: In einer Funktionseinheit 30 findet der beschriebene Vergleich zwischen erfassten Werten der Sensoren (Funktionsblock 32), entsprechend dem Temperatursensor mit einem Erfassen einer Temperatur T sowie dem Einstrahlungssensor 24 mit einer erfassten Strahlungsleistung P_{Licht}, statt; verglichen wird dieser Parametersatz mit vorgegebenen bzw. vorbestimmten Kennliniendaten einer Tabelleneinheit 34 (entsprechend der Permanentspeichereinheit 26 in Fig. 1).

Ein Vergleichssignal der Funktionseinheit 30 crt wird aufgenommen von einer Tracker-Einheit 33 (beide Einheiten 30, 33 sind in der Realisierung der Fig. 1 implementiert durch die z.B. einen Microcontroller aufweisende Steuereinheit 20), wobei als Ergebnis des Vergleiches die MPP-Tracker-Einheit 33 eine Arbeitspunktverschiebung der Wechselrichterleistung P um einen Leistungsversatz ΔP vornimmt und entsprechend den Wechselrichter 14 ansteuert.

Die so bewirkte Auslenkung des MPP-Trackers aus dem optimalen Leistungspunkt um das erforderliche ΔP vermindert die Leistung des zugeordneten Photovoltaik-Moduls 12, ist jedoch abhängig von einem aktuellen Verschattungszustand und ermöglicht daher eine Optimierung im Hinblick auf eine Belastung der Solarzellen sowie eine Gewährleistung eines sicheren Betriebs auch im beschatteten Zustand, womit insbesondere dauerhafte Schädigungen von Zellen durch (Teil-)Verschattung ausgeschlossen werden können.

Als Variante zum Vorgehen gemäß Fig. 3 zeigt das Prinzipschaltbild der Fig. 2 einen alternativen Weg, wie im Rahmen der Erfindung eine adaptive Teilverschattungserkennung für eine MPP-Tracker-Einheit 42 realisiert und in der erfindungsgemäßen Weise eine Arbeitspunktverschiebung durchgeführt werden kann. Abweisend vom Beispiel der Fig. 3, Fig. 1 sieht das Prinzip gemäß Fig. 2 vor, dass mittels einer Erfassungsleitung nᵢₙ zu jeder Solarzelle (und durch Messung einer jeweiligen Zellenspannung bzw. eines Zellenstroms auf einer solchen Leitung) eine abgeschattete Zelle erfasst werden kann. Eine Erfassungseinheit 40 berechnet aus der (der Mehrzahl der Solarzellen entsprechenden) Mehrzahl von Spannungs- oder Stromwerten einen notwendigen Leistungsversatz ΔP, um welchen durch Wirkung der MPP-Tracker-Einheit 42 die Arbeitspunktverschiebung am Wechselrichter 14 erfolgen muss. Auch hier bedeutet ΔP eine Auslenkung des MPP-Trackers 42 aus dem optimalen Leistungspunkt (mit einer entsprechenden leistungsmindernden Auswirkung auf das zugehörige Photovoltaik-Modul), diese Arbeitspunktverschiebung bewirkt jedoch wiederum, dass keine der Solarzellen des Photovoltaik-Moduls 12 (und auch nicht eine abgeschattete Zelle) in einem nachteiligen Betriebszustand, oberhalb einer Toleranzgrenze oder eines negativen elektrischen Leistungsdurchsatzes betrieben wird.

Die für die vorliegenden Ausführungsbeispiele herangezogenen Photovoltaik-Module weisen vorteilhaft organische Photovoltaik-Zellen bzw. anorganische Dünnschicht-Photovoltaik-Zellen auf, da hier der erfindungsgemäß erreichte Vorteil, Bypassdioden unnötig zu machen, besonders deutlich wird. Gleichwohl ist die vorliegende Erfindung nicht auf diese spezielle Form von Solarzellen beschränkt, vielmehr eignet sich die vorliegende Erfindung für nahezu beliebige Einsatzgebiete, bei welchen adaptiv auf wechselnde Einstrahlungs- bzw. Beschattungssituationen unter Minimierung eines schädlichen Einflusses auf einzelne Zellen reagiert werden muss. Gleichzeitig sind die oben skizzierten Lebensdauer- und Standzeitvorteile (insbesondere auch in Verbindung mit einer Gesamt-Energieausbeutesteigerung) hervorzuheben.

## Patentansprüche

1. Photovoltaik-Vorrichtung mit einem Solarzellen aufweisenden Photovoltaik-Modul (12), dem MPP-Mittel (42) zur Ermittlung eines elektrischen Leistungsmaximums des Photovoltaik-Moduls (12) und zum Einstellen eines zugehörigen Strom-Spannungs-Arbeitspunkts für einen nachgeschalteten Wechselrichter (14) zugeordnet sind,
**dadurch gekennzeichnet,**
**dass** den MPP-Mitteln (42) eine Erfassungseinheit (40) zugeordnet ist, die zum Erfassen einer jeweiligen Zellenspannung einer Mehrzahl von Solarzellen und zum Erzeugen eines Steuersignals für die MPP-Mittel (42) so ausgebildet ist, dass als Reaktion auf eine detektierte vorbestimmte Spannungsänderung einer Zellenspannung einer Solarzelle relativ zu den Zellenspannungen der anderen der Mehrzahl von Solarzellen des Photovoltaik-Moduls (12) durch Wirkung des Steuersignals eine Leistungsveränderung, insbesondere Leistungsabsenkung des Photovoltaik-Moduls (12) bewirkende Verschiebung des Strom-Spannungs-Arbeitspunkts ausgelöst wird.

2. Vorrichtung nach Anspruch 1,
**dadurch gekennzeichnet,**
**dass** die Erfassungseinheit (40) so eingerichtet ist, dass die zu detektierende vorbestimmte Spannungsänderung der Zellenspannung einer Solarzelle einer Abschattung der Solarzelle entspricht.

3. Vorrichtung nach Anspruch 1 oder 2,
**dadurch gekennzeichnet,**
**dass** für das Erfassen der jeweiligen Zellenspannungen eine der Mehrzahl von Solarzellen entsprechende Anzahl von Analyseleitungen (nᵢₙ) vorgesehen und mit der Erfassungseinheit (40) verbunden ist.

4. Photovoltaikvorrichtung mit einem Solarzellen aufweisenden Photovoltaik-Modul (12), dem MPP-Mittel (33) zur Ermittlung eines elektrischen Leistungsmaximums des Photovoltaik-Moduls (12) und zum Einstellen eines zugehörigen Strom-Spannungs-Arbeitspunkts für einen nachgeschalteten Wechselrichter (14) zugeordnet sind,
**dadurch gekennzeichnet,**
**dass** den MPP-Mitteln (42) eine Parameter-Erfassungseinheit (40) zugeordnet ist, die zum Erfassen mindestens eines von einem Beleuchtungs- und/oder Temperaturzustand der Solarzellen beeinflussten Umgebungsparameters (T, P_{licht}) ausgebildet ist,
und eine Vergleichseinheit (30) vorgesehen ist, die so mit der Parameter-Erfassungseinheit (40) zusammenwirkt, dass als Reaktion auf eine festgestellte Abweichung eines erfassten Beleuchtungs- und/oder Temperaturzustands von einem vorbestimmten Vergleichswert ein Steuersignal für die MPP-Mittel (42) erzeugt wird, das eine Leistungsabsenkung des Photovoltaik-Moduls (12) bewirkende Verschiebung des Strom-Spannungs-Arbeitspunkt auslöst.

5. Photovoltaikvorrichtung nach Anspruch 4,
**dadurch gekennzeichnet,**
**dass** die Vergleichseinheit (30) zum Auslesen des Vergleichswerts aus einer ihr zugeordneten, nichtflüchtigen Speichereinheit (34) eingerichtet ist.

6. Photovoltaikvorrichtung nach Anspruch 4 oder 5,
**dadurch gekennzeichnet,**
**dass** die Parameter-Erfassungseinheit (40) einen zum Erfassen einer Betriebstemperatur der Solarzelle ausgebildeten Temperatursensor (22) aufweist.

7. Photovoltaikvorrichtung nach einem der Ansprüche 1 bis 6,
**dadurch gekennzeichnet,**
**dass** die Parameter-Erfassungseinheit (40) einen zum Erfassen eines ganz- oder teilflächigen Lichteinfalls auf das Photovoltaik-Modul (12) ausgebildeten Lichtsensor (24) aufweist.

8. Photovoltaikvorrichtung nach einem der Ansprüche 1 bis 7,
**dadurch gekennzeichnet,**
**dass** das Photovoltaik-Modul (12) und/oder die Mehrzahl der Solarzellen keine Bypassdiode aufweist/en.

9. Photovoltaikvorrichtung nach einem der Ansprüche 1 bis 8,
**dadurch gekennzeichnet,**
**dass** die Mehrzahl der Solarzellen organische Solarzellen und/oder anorganische Dünnschicht-Solarzellen aufweisen.

10. Photovoltaikvorrichtung nach einem der Ansprüche 1 bis 9,
**dadurch gekennzeichnet,**
**dass** die Verschiebung des Strom-Spannungs-Arbeitspunkts so erfolgt, dass in diesem Betriebszustand keine der Mehrzahl der Solarzellen einen negativen elektrischen Leistungsdurchsatz aufweist oder dass eine zellspezifische Toleranzgrenze einer Solarzelle nicht überschritten wird.

## Claims

1. Photovoltaic device comprising a photovoltaic module (12) having solar cells, said photovoltaic module being assigned MPP means (42) for determining an electrical power maximum of the photovoltaic module (12) and for setting an associated current-voltage operating point for an inverter (14) connected downstream,
**characterized**
**in that** the MPP means (42) are assigned a detection unit (40) designed for detecting a respective cell voltage of a plurality of solar cells and for generating a control signal for the MPP means (42) such that as a reaction to a detected predetermined voltage change of a cell voltage of a solar cell relative to the cell voltages of the other solar cells from the plurality of solar cells of the photovoltaic module (12), as a result of the effect of the control signal, a shift of the current-voltage operating point is initiated, which shift brings about a change in power, in particular decrease in power of the photovoltaic module (12).

2. Device according to Claim 1,
**characterized**
**in that** the detection unit (40) is designed such that the predetermined voltage change of the cell voltage of a solar cell that is to be detected corresponds to a shading of the solar cell.

3. Device according to Claim 1 or 2,
**characterized**
**in that**, for detecting the respective cell voltages, a number of analysis lines (nᵢₙ) corresponding to the plurality of solar cells are provided and connected to the detection unit (40).

4. Photovoltaic device comprising a photovoltaic module (12) having solar cells, said photovoltaic module being assigned MPP means (33) for determining an electrical power maximum of the photovoltaic module (12) and for setting an associated current-voltage operating point for an inverter (14) connected downstream,
**characterized**
**in that** the MPP means (42) are assigned a parameter detection unit (40) designed for detecting at least one ambient parameter (T, P_{light}) influenced by an illumination and/or temperature state of the solar cells,
and a comparison unit (30) is provided, which interacts with the parameter detection unit (40) such that as a reaction to an established deviation of a detected illumination and/or temperature state from a predefined comparison value, a control signal is generated for the MPP means (42), which control signal initiates a shift of the current-voltage operating point, which shift brings about a decrease in power of the photovoltaic module (12).

5. Photovoltaic device according to Claim 4,
**characterized**
**in that** the comparison unit (30) is designed for reading out the comparison value from a non-volatile memory unit (34) assigned to said comparison unit.

6. Photovoltaic device according to Claim 4 or 5,
**characterized**
**in that** the parameter detection unit (40) has a temperature sensor (22) designed for detecting an operating temperature of the solar cell.

7. Photovoltaic device according to any of Claims 1 to 6,
**characterized**
**in that** the parameter detection unit (40) has a light sensor (24) designed for detecting whole- or partial-area light incidence on the photovoltaic module (12).

8. Photovoltaic device according to any of Claims 1 to 7,
**characterized**
**in that** the photovoltaic module (12) and/or the plurality of solar cells have/has no bypass diode.

9. Photovoltaic device according to any of Claims 1 to 8,
**characterized**
**in that** the plurality of solar cells comprise organic solar cells and/or inorganic thin-film solar cells.

10. Photovoltaic device according to any of Claims 1 to 9,
**characterized**
**in that** the current-voltage operating point is shifted such that in this operating state none of the plurality of solar cells has a negative electrical power throughput or that a cell-specific tolerance limit of a solar cell is not exceeded.

## Revendications

1. Dispositif photovoltaïque comportant un module photovoltaïque (12) comprenant des cellules solaires, auquel sont associés des moyens MPP (42) destinés à calculer un maximum de puissance électrique du module photovoltaïque (12) et à régler un point de fonctionnement de courant-tension correspondant pour un onduleur connecté en aval (14),
**caractérisé**
**en ce qu'**une unité de détection (40), qui est conçue pour détecter une tension de cellule respective d'une pluralité de cellules solaires et pour générer un signal de commande destiné aux moyens MPP (42), est associée aux moyens MPP (42) de manière à ce qu'en réaction à une variation de tension prédéterminée détectée d'une tension de cellule d'une cellulaire solaire par rapport aux tensions de cellules des autres de la pluralité de cellules solaires du module photovoltaïque (12), une modification de puissance soit déclenchée sous l'effet du signal de commande, notamment un décalage du point de fonctionnement de courant-tension provoquant une diminution de la puissance du module photovoltaïque (12).

2. Dispositif selon la revendication 1,
**caractérisé en ce que** l'unité de détection (40) est conçue de manière à ce que la variation de tension prédéterminée à détecter de la tension de cellule d'une cellule solaire correspond à une dégradation de la cellule solaire.

3. Dispositif selon la revendication 1 ou 2, **caractérisé en ce que**, pour détecter les tensions de cellules respectives, il est prévu un nombre de conducteurs d'analyse (nᵢₙ) qui correspond à la pluralité de cellules solaires, et auxquels est connectée l'unité de détection (40).

4. Dispositif photovoltaïque comportant un module photovoltaïque (12) comprenant des cellules solaires, auquel sont associés des moyens MPP (33) destinés à calculer un maximum de puissance électrique du module photovoltaïque (12) et à régler un point de fonctionnement de courant-tension correspondant pour un onduleur connecté en aval (14),
**caractérisé en ce qu'**une unité de détection de paramètres (40) est associée aux moyens MPP (42), laquelle unité est conçue pour détecter au moins un paramètre d'environnement (T, P_{LICHT}) influencé par un état d'éclairage et/ou de température des cellules solaires,
et **en ce qu'**il est prévu une unité de comparaison (30) qui coopère avec l'unité de détection de paramètres (40) de manière à ce qu'en réaction à un écart déterminé d'un état d'éclairage et/ou de température détecté par rapport à une valeur de comparaison prédéterminée, un signal de commande destiné aux moyens MPP (42) soit généré, celui-ci déclenchant un décalage du point de fonctionnement de courant-tension provoquant une diminution de puissance du module photovoltaïque (12).

5. Dispositif photovoltaïque selon la revendication 4, **caractérisé en ce que** l'unité de comparaison (30) est conçue pour lire la valeur de comparaison depuis une unité à mémoire (34) non volatile qui lui est associée.

6. Dispositif photovoltaïque selon la revendication 4 ou 5, **caractérisé en ce que** l'unité de détection de paramètres (40) comprend un capteur de température (22) conçu pour détecter une température de fonctionnement de la cellule solaire.

7. Dispositif photovoltaïque selon l'une quelconque des revendications 1 à 6, **caractérisé en ce que** l'unité de détection de paramètres (40) comporte un capteur de lumière (24) conçu pour détecter une incidence de lumière sur la totalité ou une partie de la surface, sur le module photovoltaïque (12).

8. Dispositif photovoltaïque selon l'une quelconque des revendications 1 à 7, **caractérisé en ce que** le module photovoltaïque (12) et/ou la pluralité de cellules solaires ne comprend/comprennent aucune diode de dérivation.

9. Dispositif photovoltaïque selon l'une quelconque des revendications 1 à 8, **caractérisé en ce que** la pluralité de cellules solaires comprennent des cellules solaires organiques et/ou des cellules solaires à couches minces inorganiques.

10. Dispositif photovoltaïque selon l'une quelconque des revendications 1 à 9, **caractérisé en ce que** le décalage du point de fonctionnement de courant-tension est effectué de manière à ce que, dans cet état de fonctionnement, aucune de la pluralité des cellules solaires ne présente un débit de puissance électrique négatif ou à ce qu'une limite de tolérance d'une cellule solaire, qui est spécifique des cellules, ne soit pas dépassée.
